(19) Europäisches Patentamt

European Patent Office

Office européen des brevets

(11) **EP 1 056 127 A2**

(12) **EUROPEAN PATENT APPLICATION**

(43) Date of publication:
**29.11.2000 Bulletin 2000/48**

(51) Int. Cl.$^7$: **H01L 21/66**

(21) Application number: **00303877.5**

(22) Date of filing: **09.05.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **21.05.1999 US 135236 P**

(71) Applicant:
**LUCENT TECHNOLOGIES INC.**
**Murray Hill, New Jersey 07974-0636 (US)**

(72) Inventors:
• **Cruceta, Sergio**
 **Mostoles (ES)**
• **Garcia, Alfredo**
 **IE Madrid (ES)**
• **Merino, Miguel Angel**
 **8A Madrid (ES)**

(74) Representative:
**Buckley, Christopher Simon Thirsk et al**
**Lucent Technologies (UK) Ltd,**
**5 Mornington Road**
**Woodford Green, Essex IG8 0TU (GB)**

(54) **Method and apparatus for correlating data from a semiconductor wafer process**

(57)    A method for correlating detected defects occurring during making of an array of memory cells to failed memory cells therein includes inspecting the array of memory cells to detect defects occurring during making thereof, and testing the array of memory cells to determine the failed memory cells. Clusters are formed for the spaced apart failed memory cells, and the detected defects are correlated with the formed clusters of spaced apart failed memory cells. Each formed cluster of spaced apart failed memory cells is based upon proximity between the failed memory cells. In addition, each formed cluster of spaced apart failed memory cells is defined as a predetermined shape so that the correlation process is made less complex when comparing detected defects to failed memory cells. Clustering thus treats spaced apart failed memory cells that are in close proximity to one another as a single failure since the failures are likely to be caused by the same defect.

## Description

## Field of the Invention

The present invention relates to the field of semiconductor wafer processing, and, more particularly, to a method and apparatus for correlating data from a semiconductor wafer process for increasing the yield of semiconductor wafers.

## Background of the Invention

Semiconductor wafer processing involves complex process steps to form devices on the surface of a silicon wafer. A goal of semiconductor wafer processing is to attain a high yield. Yield is a percentage which indicates the amount of good devices in a wafer divided by the total number of devices in that wafer.

A number of discrete process steps are required to form a device including an array of memory cells from raw semiconductor material. The starting substrate is usually a slice of single crystal silicon referred to as the wafer. A plurality of devices are fabricated together in batches of wafers called lots or runs. The individual wafers in a lot may go through individual process steps one at a time or as a batch. At the completion of the process steps, the devices are tested to determine circuit functionality.

A method of analyzing a failure in a device comprising an array of memory cells is done by testing an electrical property of each memory cell. A tester is used to test each memory cell, and the resultant data is provided in a coordinate space of rows (X) and columns (Y) to produce a failure pattern. This pattern is generally called a bitmap failure, and corresponds to the cause of the failures. The bitmap may also be referred to as a map of failed memory cells. A cause of the failure is estimated using the bitmap.

The cause of the failure obtained with the bitmap is an estimation of the failure and an electrical abnormality at that position, i.e., an estimation of what failure is happening at which position. Failures may be a result of particle contamination, leakages, opens or shorts resulting during an individual process step.

To correct the failure, the cause of the failure in the process step must be clarified. One such approach is disclosed in U.S. Patent No. 5,844,850 to Tsutsui et al. A physical inspection for defects is performed at a surface of each memory device using a defect inspection device for each process step in the production line. An electrical property of the memory cells in each array of memory cells is also tested by a tester to produce the bitmap. The result of the physical inspection is correlated with the bitmap, thereby allowing estimation as to whether a failure is caused by foreign materials, defects and the like during the manufacturing process.

Unfortunately, the cause of a failure is not always located at the position of the failure found by the tester, and there are many cases where the cause of a failure is located at a position other than the position of the failure. In other words, correlation of detected defects and failed memory cells does not always provide proper relationships therebetween. Moreover, not all the foreign materials and defects produced during the manufacturing process cause a failure, and whether foreign materials or defects cause a failure or not depends on the position, size and the like thereof. Therefore, there is a need to improve the way information on detected defects and tailed memory cells are correlated for a semiconductor wafer process.

## Summary of the Invention

In view of the foregoing background, it is therefore an object of the present invention to correlate data from a semiconductor manufacturing process so that corrective action can be taken for increasing wafer yield

This and other objects, features and advantages in accordance with the present invention are provided by a method for correlating detected defects occurring during making of an array of memory cells to failed memory cells in the array of memory cells. The method preferably includes inspecting the array of memory cells to detect defects occurring during making thereof, and testing the array of memory cells to determine failed memory cells. Clusters of spaced apart failed memory cells are preferably formed, and the detected defects are preferably correlated with the formed clusters of failed memory cells.

Each formed cluster of failed memory cells is preferably based upon a predetermined separation distance between the spaced apart failed memory cells. The method preferably further includes defining each formed cluster as a predetermined shape, such as a rectangle or square. The correlating preferably determines if a detected defect is within a predetermined distance from the predetermined shape of a formed cluster.

In other words, each formed cluster of failed memory cells is based upon proximity between the spaced apart failed memory cells. In addition, each formed cluster of failed memory cells is defined as a predetermined shape so that the correlation process is made less complex when comparing detected defects to failed memory cells. Clustering thus treats spaced apart failed memory cells that are in close proximity to one another as a single failure since the failures are likely to be caused by the same defect. Each array of memory cells preferably forms a random access memory, which may be part of a stand alone memory device, such as a DRAM or SRAM, or the random access memory may be an embedded memory within a digital signal processor, for example.

Another aspect of the invention relates to a correlation device. The correlation device preferably includes a defect inspection device for detecting defects in a wafer comprising a plurality of devices, with each device comprising an array of memory cells. The correlation device also preferably includes a tester for testing each array of memory cells to determine failed memory cells. The defect inspection device preferably optically inspects the memory cells, whereas the tester preferably uses electrical signals to test the memory cells. Each of the memory cells preferably comprises a random access memory cell.

A processor is preferably connected to the defect inspection device and the tester for forming clusters of spaced apart failed memory cells, and for correlating the detected defects with the formed clusters of failed memory cells based upon the information provided therefrom. A memory is preferably connected to the processor for storing location of the detected defects, location of the formed clusters of failed memory cells, and the correlation therebetween. The correlation device preferably further includes a display connected to the processor for displaying correlation of the detected defects and the formed clusters of failed memory cells.

Each formed cluster of failed memory cells is preferably based upon a predetermined separation distance between the spaced apart failed memory cells. When a cluster is formed, it is preferably defined as a predetermined shape by the processor so that when the processor correlates the detected defects with the formed clusters, a determination is made if a detected defect is within a predetermined distance from the predetermined shape of the formed cluster. The predetermined shape is preferably rectangular shaped.

## Brief Description of the Drawings

FIG. 1 is a flowchart illustrating a method for correlating detected defects and failed memory cells in accordance with the present invention.
FIG. 2 is a schematic block diagram of a correlation device in accordance with the present invention.
FIGS. 3a is a bitmap diagram illustrating spaced apart failed memory cells within an array of memory cells, and FIG. 3b is the bitmap diagram of FIG. 3a illustrating clustering of the spaced apart failed memory cells in accordance with the present invention.
FIG. 4 is a flowchart illustrating the clustering algorithm in accordance with the present invention.
FIG. 5 is the bitmap diagram of FIG. 3b overlaid with the detected defects in accordance with the present invention.

## Detailed Description of the Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

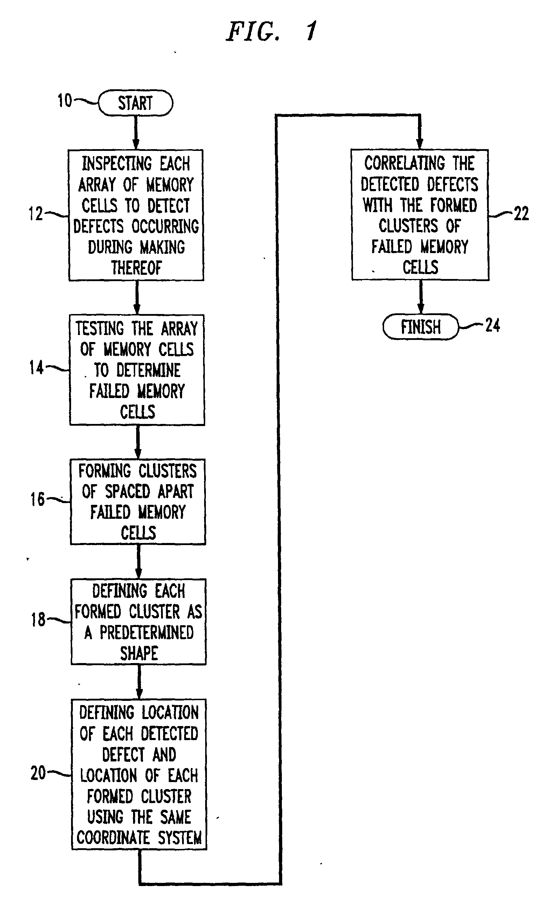

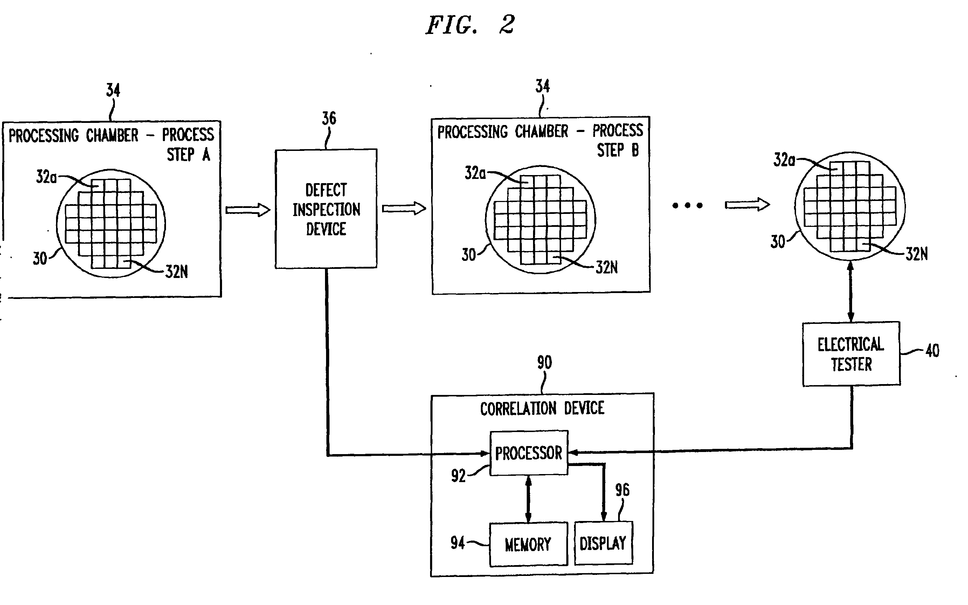

A method for correlating detected defects occurring during making of an array of memory cells to failed memory cells therein is now described with reference to FIGS. 1-5. At least one wafer **30** comprising a plurality of devices **32a-32n** (FIG. 2) is formed. Each device, generally represented by reference **32**, comprises an array of memory cells. The array of memory cells are arranged in a matrix of rows and columns to define a random access memory. The random access memory may be part of a DRAM or SRAM, as readily appreciated by one skilled in the art. Moreover, the random access memory may be embedded in the device, with the device being a digital signal processor (DSP), for example. The process steps are performed in a processing chamber **34**, as shown in FIG. 2.

From the start (Block **10**) of the correlation process, each array of memory cells is inspected at Block **12** to detect defects occurring during making thereof. For example, an in-line production flow of the wafer **30** includes process steps A and B being formed in the processing chamber **34**, with a defect inspection device **36** being used between the process steps for inspecting the surface of each device **32**. Process step A may form a metal layer, whereas process step B may form a dielectric layer over the metal layer, for example.

The defect inspection device **36** optically inspects the external appearance of the array of memory cells between the process steps A and B for particle contamination, opens, shots, and the like that may have been introduced as a result of process step A. For example, process step A may include defective photolithography or etching.

After the process steps have been completed, the array of memory cells are tested at Block **14** to determine failed memory cells. As shown in FIG. 2, an electrical tester **40** using electrical signals determines which memory cells have failed. After determination of which memory cells have failed within the array of memory cells, clusters or groups of failed memory cells are formed at Block **16** in accordance with the present invention. As will be explained in greater detail, clustering is an important process when correlating detected defects with failed memory cells.

Correlating failed memory cells with detected defects is a complex process because of the large amount of failures typically present in any array of memory cells. The failed memory cells may also be referred to as bits. The basic concept of clustering is to treat spaced apart failed memory cells that are in close proximity to one another as a single failure since the failures are likely to be caused by the same defect. Consequently, correlating a detected defect with a cluster of failed memory cells causes the correlating process to be less complex.

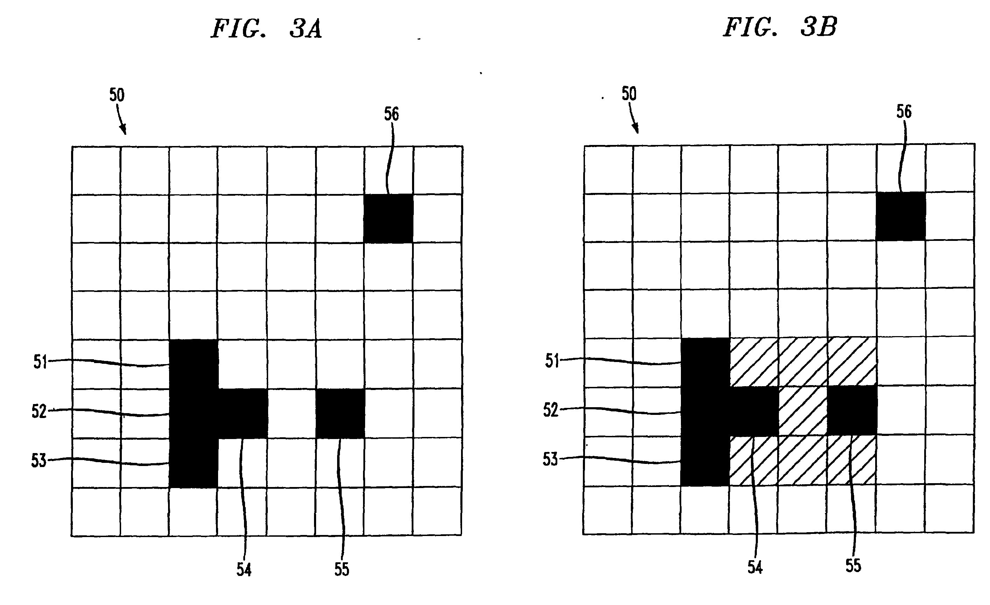

Referring to FIG. 3a, a bitmap diagram **50** of an array of memory cells is shown, wherein filled-in or shaded blocks represent failed memory cells. Clustering in accordance with the present invention determines a separation distance between failed memory cells, and if the separation distance is less than a predetermined separation distance, then the spaced apart memory cells form a cluster. For example, the predetermined separation distance may be less than about 50 microns. However, this number can vary depending on the actual dimensions of each memory cell.

Failed memory cells **51-54** are all within the predetermined separation distance and are considered to be part of a formed cluster, for example. In addition, spaced apart failed memory cell **55** is also within the predetermined separation distance and is included as part of the formed cluster. However, failed memory cell **56** is beyond the predetermined separation distance and is not part of the formed cluster. Failed memory cell **56** is referred to as a single bit cluster, whereas failed memory cells **51-55** are referred to as a clump cluster.

When an in-line process defect causes memory cells to fail, the failed memory cells may be dispersed throughout the array of memory cells. In other words, the failed memory cells may not always be immediately adjacent other failed memory cells when linked to the same in-line process defect. The dispersion of failed memory cells, such as failed memory cell **55**, is largely attributed to the memory array structure, as readily understood by one skilled in the art. Therefore, to obtain meaningful correlation between detected defects occurring during making of the array of memory cells to the memory cells that actually failed, clustering of the failed memory cells is necessary.

After a cluster of failed memory cells has been formed, a predetermined shape is defined for the cluster at Block **18**. The predetermined shape is preferably rectangular or square shaped. Referring now to FIG. 3b, failed memory cells **51-54** and **55** are defined as a rectangular shape, as indicated by the cross hatched markings of functional memory cells combined with the filled-in regions of the failed memory cells. Even though the rectangular shaped area includes memory cells that have not failed, classifying the cluster of failed memory cells as a rectangular shape makes the correlation process less complex. The single bit cluster of failed memory cell **56** is likewise defined as a square shape. Even though the predefined shape is a rectangle or square, other shapes may also be utilized by the clustering algorithm.

A location of each formed cluster of failed memory cells is defined using a predetermined coordinate system, and a location of each detected defect is defined using the same predetermined coordinate system at Block **20**. Initially, location of a failed memory cell is defined by row and column within the array of memory cells. After a formed cluster of failed memory cells has been defined as a predetermined shape, such as the rectangle shape illustrated in FIG. 3b, its location is identified using x-y coordinates instead of rows and columns.

For example, the following information, as a minimum, identifies location of a formed cluster of failed memory cells while allowing correlation with detected defects:

- memory array X coordinate (integer)
- memory array Y coordinate (integer)

  - X position of the formed cluster relative to the memory array origin
  - Y position of the formed cluster relative to the memory array origin

- form cluster X length
- form cluster Y length

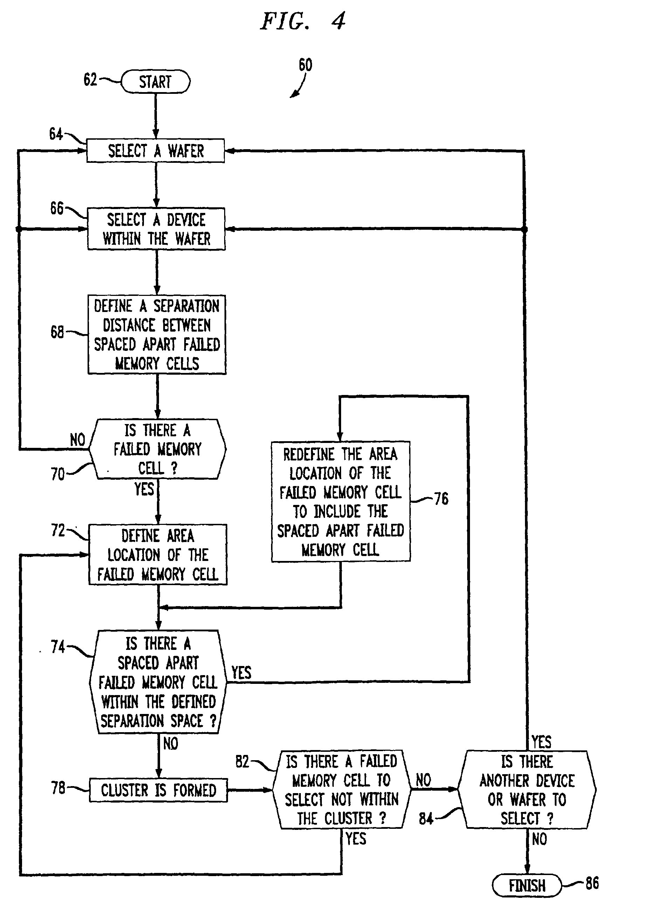

The clustering algorithm **60** in accordance with the present invention will now be described in greater detail with reference to the flowchart illustrated in FIG. 4. From the start (Block **62**), a processed wafer **30** is selected at Block **64**, and a device **32a** within the processed wafer is selected at Block **66**. At Block **68**, a predetermined separation distance between spaced apart failed memory cells is defined. The predetermined separation distance is defined as x_shift in the x-axis direction, and as y_shift in the y-axis direction. The predetermined separation distance may be based upon a ratio of a predetermined number RADIUS and the length L or width W of a memory cell.

In other words, the predetermined separation distance in the x-axis direction is defined by the ratio of RADIUS/L, where L is the length of a memory cell. Similarly, the predetermined separation distance in the y-axis direction is defined by the ratio of RADIUS/W, where W is the width of the memory cell. If the memory cell is symmetrical, then $L = W$.

At Block **70** a determination is made if there is a failed memory cell within the selected device **32a**. If there is a failed memory cell, then an area location of the failed memory cell is determined. Based upon the initial x-y coordinates of the failed memory cell, minimum and maximum coordinates are defined for the x and y axis using the predetermined separation distance. For example, the information generated at Block **72** is as follows:

x_min = x_failed memory cell - x_shift

y_min = y_failed memory cell - y_shift

x_max = x_failed memory cell + x_shift

y_max = y_failed memory cell + y_shift

A determination is then made at Block **74** as to whether there is a failed memory cell within the defined predetermined separation space surrounding the area location of the failed memory cell. If there is a failed memory cell within the defined separation space, then the area location of the failed memory cell is redefined at Block **76** to include this failed memory cell. The rectangular shape of the formed cluster is thus redefined. For example, the redefined or updated information generated at Block **76** is as follows:

x_min = min(x_ min x_failed memory cell - x_shift)

y_min = min(y_min, y_failed memory cell - y_shift)

x_max = max(x_max, x_failed memory cell + x_shift)

y_max = max(y_max, y_failed memory cell + y_shift)

The clustering algorithm loops back to the decision Block **74** to determine whether there is another spaced apart failed memory cell within the redefined area location of the formed cluster. If there are no more failed memory cells to include within the cluster, then the cluster is considered formed or closed at Block **78**. If there is a failed memory cell to select not within the formed cluster (Block **82**), then steps **72-78** are repeated. If there is another device or wafer to select as determined at Block **84**, then steps **64-82** are repeated. The clustering algorithm is finished at Block **86**.

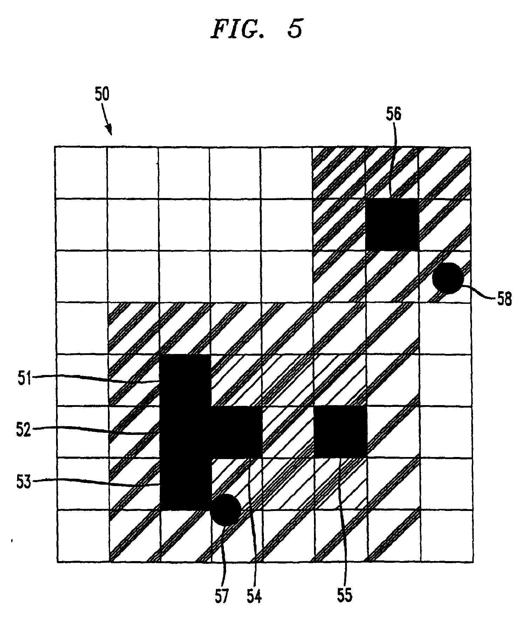

After the failed memory cells have been clustered, the detected defects are correlated with the formed clusters of failed memory cells. As part of the correlation process, an overlapping radius is defined to surround the predetermined shapes of the formed clusters. Referring to FIG. 5, the overlapping radius is illustrated by the thicker marked cross hatched lines surrounding each formed cluster of failed memory cells. If a detected defect is within the overlapping radius as extended from any edge of the formed clusters of failed memory cells, then the two are correlated together. For example, detected defect **57** is within the overlapping radius for failed memory cells **51-55**, and detected defect **58** is within the overlapping radius for failed memory cell **56**. The overlapping radius may be less than about 50 microns. However, this number can vary depending on the actual dimensions of each memory cell.

Another aspect of the invention relates to the correlation device **90** as illustrated in FIG. 2. The correlation device **90** includes the defect inspection device **36** for detecting defects in a wafer **30** comprising a plurality of devices **32a-32n**, with each device comprising an array of memory cells. The correlation device **90** also includes the tester **40** for testing each array of memory cells to determine failed memory cells. The defect inspection device **36** optically inspects the memory cells, whereas the tester **40** uses electrical signals to test the memory cells. Each of the memory cells comprises a random access memory cell.

A processor **92** is connected to the defect inspection device **36** and the tester **40** for forming clusters of spaced apart failed memory cells and for correlating the detected defects with the formed clusters of failed memory cells based upon the information provided therefrom. A memory **94** is connected to the processor **92** for storing location of the detected defects, location of the formed clusters of failed memory cells, and the correlation therebetween. The correlation device further includes a display **96** connected to the processor **92** for displaying correlation of the detected defects and the formed clusters of failed memory cells.

Each formed cluster of failed memory cells is based upon a predetermined separation distance between the failed memory cells, and the predetermined separation distance may be less than about 50 microns between any two spaced apart failed memory cells. When a cluster is formed, it is defined as a predetermined shape by the processor **92**, so that when the processor correlates the detected defects with the formed clusters, a determination is made if a detected defect is within a predetermined distance from the predetermined shape of the formed cluster. The predetermined distance may be less than about 50 microns, and the predetermined shape is generally rectangular shaped.

Many modifications and other embodiments of the invention will come to the mind of one skilled in the art having the benefit of the teachings presented in the foregoing descriptions and the associated drawings. Therefore, it is to be understood that the invention is not to be limited to the specific embodiments disclosed, and that modifications and embodiments are intended to be included within the scope of the appended claims.

**Claims**

1. A method for correlating detected defects occurring during making of an array of memory cells to failed memory cells in the array of memory cells, the method comprising:

inspecting the array of memory cells to detect defects occurring during making thereof;

testing the array of memory cells to determine failed memory cells;

forming clusters of spaced apart failed memory cells; and

correlating the detected defects with the formed clusters of spaced apart failed memory cells.

2. A method according to Claim 1 wherein the making of each array of memory cells is done in successive layers; and wherein inspecting comprises inspecting each layer.

3. A method for processing semiconductor wafers comprising:

performing process steps to make at least one wafer comprising a plurality of devices with each device comprising an array of memory cells;
inspecting each array of memory cells to detect defects occurring during making thereof;
testing each array of memory cells to determine failed memory cells;
forming clusters of spaced apart failed memory cells;
correlating the detected defects with the clusters of failed memory cells; and
using the correlated detected defects and the formed clusters of spaced apart failed memory cells to determine if corrective action is needed.

4. A method according to Claim 1 or 3 wherein each formed cluster of spaced apart failed memory cells is based upon a predetermined separation distance between the failed memory cells.

5. A method according to claim 4 wherein the predetermined separation distance is less than about 50 microns between any two spaced apart failed memory cells.

6. A method according to Claim 1 or 3 wherein forming clusters of spaced apart failed memory cells further comprises defining each formed cluster as a predetermined shape.

7. A method according to Claim 6 wherein correlating comprises determining if a detected defect is within a predetermined distance from the predetermined shape of a formed cluster.

8. A method according to Claim 7 wherein the predetermined distance is less than about 50 microns.

9. A method according to Claim 6 wherein the predetermined shape is generally rectangular shaped.

10. A method according to Claim 1 or 3 further comprising:

defining a location of each detected defect using a predetermined coordinate system; and
defining a location of each formed cluster using the predetermined coordinate system.

11. A method according to Claim 3 wherein

performing the process steps comprises forming each array of memory cells in successive layers; and wherein inspecting comprises inspecting each layer.

12. A method according to Claim 1 or 3 wherein each of the memory cells comprises a random access memory cell.

13. A method according to Claim 1 or 3 wherein inspecting comprises optically inspecting.

14. A correlation device comprising:

a defect inspection device for detecting defects in a wafer comprising a plurality of devices with each device comprising an array of memory cells;
a tester for testing each array of memory cells to determine failed memory cells; and
a processor connected to said defect inspection device and said tester for forming clusters of spaced apart failed memory cells and for correlating the detected defects with the formed clusters of spaced apart failed memory cells.

15. A correlation device according to Claim 14 further comprising a memory connected to said processor for storing location of the detected defects, location of the formed clusters of spaced apart failed memory cells, and the correlation therebetween.

16. A correlation device according to Claim 14 further comprising a display connected to said processor for displaying correlation of the detected defects and the formed clusters of spaced apart failed memory cells.

17. A correlation device according to Claim 14 wherein each formed cluster of spaced apart failed memory cells is based upon a predetermined separation distance between the failed memory cells.

18. A correlation device according to Claim 17 wherein the predetermined separation distance is less than about 50 microns between any two failed memory cells.

19. A correlation device according to Claim 14 wherein forming clusters of failed memory cells further comprises defining each formed cluster as a predetermined shape.

20. A correlation device according to Claim 19 wherein correlating comprises determining if a detected defect is within a predetermined distance from the predetermined shape of a formed cluster.

21. A correlation device according to Claim 19 wherein the predetermined distance is less than about 50 microns.

22. A correlation device according to Claim 19 wherein the predetermined shape is generally rectangular shaped.

23. A correlation device according to Claim 14 wherein the memory cells are processed in successive layers; and wherein said defect inspection device inspects each layer.

24. A correlation device according to Claim 14 wherein said defect inspection device optically inspects the memory cells.

25. A correlation device according to Claim 14 wherein each of the memory cells comprises a random access memory cell.

26. A correlation device according to Claim 14 wherein said tester comprises and electrical tester.

## FIG. 1

10 — START

12 — INSPECTING EACH ARRAY OF MEMORY CELLS TO DETECT DEFECTS OCCURRING DURING MAKING THEREOF

14 — TESTING THE ARRAY OF MEMORY CELLS TO DETERMINE FAILED MEMORY CELLS

16 — FORMING CLUSTERS OF SPACED APART FAILED MEMORY CELLS

18 — DEFINING EACH FORMED CLUSTER AS A PREDETERMINED SHAPE

20 — DEFINING LOCATION OF EACH DETECTED DEFECT AND LOCATION OF EACH FORMED CLUSTER USING THE SAME COORDINATE SYSTEM

22 — CORRELATING THE DETECTED DEFECTS WITH THE FORMED CLUSTERS OF FAILED MEMORY CELLS

FINISH — 24

## FIG. 2

EP 1 056 127 A2

FIG. 3B

FIG. 3A

## FIG. 4

60

62 — ( START )

64 — SELECT A WAFER

66 — SELECT A DEVICE WITHIN THE WAFER

68 — DEFINE A SEPARATION DISTANCE BETWEEN SPACED APART FAILED MEMORY CELLS

70 — IS THERE A FAILED MEMORY CELL ?
NO
YES

72 — DEFINE AREA LOCATION OF THE FAILED MEMORY CELL

76 — REDEFINE THE AREA LOCATION OF THE FAILED MEMORY CELL TO INCLUDE THE SPACED APART FAILED MEMORY CELL

74 — IS THERE A SPACED APART FAILED MEMORY CELL WITHIN THE DEFINED SEPARATION SPACE ?
YES
NO

78 — CLUSTER IS FORMED

82 — IS THERE A FAILED MEMORY CELL TO SELECT NOT WITHIN THE CLUSTER ?
NO
YES

IS THERE ANOTHER DEVICE OR WAFER TO SELECT ?
84
YES
NO

( FINISH ) — 86

11

FIG. 5